(19) Europäisches Patentamt
European Patent Office
Office européen des brevets

(11) **EP 1 073 324 B1**

(12) **FASCICULE DE BREVET EUROPEEN**

(45) Date de publication et mention
de la délivrance du brevet:
**09.07.2008 Bulletin 2008/28**

(51) Int Cl.:
***H05K 9/00*** *(2006.01)*

(21) Numéro de dépôt: **00402131.7**

(22) Date de dépôt: **25.07.2000**

(54) **Dispositif de protection électromagnétique pour un tiroir**

Elektromagnetische Abschirmvorrichtung für eine Schublade

Electromagnetic protection device for a drawer

(84) Etats contractants désignés:
**AT BE CH CY DE DK ES FI FR GB GR IE IT LI LU MC NL PT SE**

(30) Priorité: **30.07.1999 FR 9910097**

(43) Date de publication de la demande:
**31.01.2001 Bulletin 2001/05**

(73) Titulaire: **Alstom**
**92300 Levallois-Perret (FR)**

(72) Inventeur: **Ruque, Christian**
**69960 Corbas (FR)**

(74) Mandataire: **de Lambilly Delorme, Marie Pierre et al**
**ALSTOM**
**Legal Intellectual Property**
**3 avenue André Malraux**
**92309 Levallois Perret (FR)**

(56) Documents cités:
**DE-A- 4 309 084          US-A- 3 502 784**

• **"RADIO FREQUENCY INTERFERENCE SUPPRESSION CLIP AND MECHANICAL GUIDANCE AID" IBM TECHNICAL DISCLOSURE BULLETIN, US, IBM CORP. NEW YORK, vol. 32, no. 8B, 1 janvier 1990 (1990-01-01), pages 264-265, XP000082476 ISSN: 0018-8689**

## Description

L'invention a trait à un dispositif de protection électromagnétique pour un tiroir équipé de cartes électroniques.

Il est connu de protéger un dispositif électronique contre les perturbations électromagnétiques venues de l'extérieur et de confiner les ondes électromagnétiques qu'il peut émettre afin d'éviter la perturbation de dispositifs voisins. Pour résoudre les problèmes de compatibilité électro-électrique, il est connu du document DE 43 09 084 de blinder les six faces d'un tiroir pour en isoler le volume intérieur par rapport à l'atmosphère ambiante. Cette approche résout les problèmes liés aux perturbations électromagnétiques mais génèrent les problèmes suivants :

- Obligation de créer une nouvelle gamme de tiroirs intégrant un blindage.
- Obligation d'intégrer des éléments de contact, par exemple à ressort, entre les faces du tiroir de façon à créer une continuité électromagnétique entre celles-ci.
- Obligation de recourir à des traitements spécifiques des faces du tiroir de façon à assurer un bon contact électrique dans le temps y compris dans un environnement de brouillard salin.
- Perturbation du flux d'air de refroidissement des composants électroniques inclus dans le tiroir car les faces blindées gênent la circulation d'air.
- Nécessité de créer un système spécifique de fixation de cartes électroniques dans le tiroir qui permet la mise en place des cartes dans le tiroir en tenant compte du jeu fonctionnel nécessaire tout en assurant une continuité électrique entre ces cartes, notamment en face avant du tiroir. Une telle mécanique est complexe et généralement réalisée par plusieurs pièces conductrices juxtaposées entre lesquelles sont disposés des moyens de contact électrique, tels qu'un ressort, d'un coût relativement important et dont la fiabilité n'est pas garantie. En outre, il convient également de masquer les emplacements vides de cartes afin de combler l'ouverture laissée en face avant.

Par ailleurs, il est connu de FR-A-2 743 977 d'employer un tiroir dont la carte-mère est disposée à proximité de la face avant, les différentes cartes étant disposées entre cette carte-mère et des connecteurs de sortie prévus sur l'arrière du tiroir. Un tel tiroir n'est pas traité sur le plan de la compatibilité électromagnétique.

C'est à ces inconvénients qu'entend plus particulièrement remédier l'invention en proposant un nouveau dispositif de protection électromagnétique plus simple, plus fiable et moins onéreux que ceux de l'état de la technique et compatible avec un tiroir de type débrochable.

Dans cet esprit, l'invention concerne un dispositif de protection électromagnétique pour un tiroir équipé de cartes électroniques et apte à être introduit dans une structure d'accueil à travers une ouverture prévue en face avant de cette structure, ce dispositif comprenant six faces réparties autour des cartes, caractérisé en ce que l'une des faces de ce dispositif est formée par la face avant du tiroir alors que les cinq autres faces de ce dispositif sont formées par les faces latérales, supérieure, inférieure et arrière de cette structure d'accueil qui sont électriquement conductrices.

L'invention permet donc de créer une structure d'isolation électromagnétique à partir d'un tiroir débrochable dont seule la face avant est traitée sur le plan de la compatibilité électromagnétique. Le reste de la protection électromagnétique est formé par les cinq faces de la structure d'accueil, telle qu'un boîtier, cette structure d'accueil ayant, le plus souvent, déjà des faces latérales supérieure, inférieure et arrière, de telle sorte que l'invention n'induit pas de modifications importantes de cette structure.

La fonction de protection électromagnétique ne nécessite aucune intervention autre que l'introduction du tiroir dans sa structure d'accueil. En effet, lorsque le tiroir est en place dans la structure d'accueil, les six faces du dispositif définissent un volume fermé, à l'intérieur duquel sont disposées des cartes électroniques du tiroir et qui est isolé sur le plan électromagnétique par rapport à l'extérieur. Le tiroir électronique peut être d'un type standard et, en particulier, ne pas comporter de capot supérieur et inférieur. Le fond du tiroir peut ne comporter que des dispositifs de connexion, aucune isolation électromagnétique ne devant être réalisée à ce niveau. En outre, les connecteurs utilisés entre le tiroir et la structure d'accueil n'ont pas besoin d'être blindés puisqu'ils sont localisés à l'intérieur du volume défini par les six faces du dispositif de protection. Le tiroir peut donc être léger car il ne comporte pas d'élément de protection électromagnétique sur ces faces latérales, supérieure, inférieure et arrière. La dissipation thermique de l'échauffement générée au niveau des composants électroniques n'est par gênée par des faces supérieure et inférieure du tiroir qui viendraient à s'opposer à la circulation d'air par convection naturelle.

Selon un premier aspect avantageux de l'invention, le dispositif comprend des moyens élastiques de liaison électrique entre la face avant du tiroir et la structure d'accueil. Ces moyens élastiques, qui peuvent être formés par des ressorts électriquement conducteurs disposés sur les bords de l'ouverture prévus en face avant de la structure et/ou sur le tiroir, permettent d'assurer la continuité électrique entre la face avant du tiroir et les faces latérales, supérieure et inférieure de la structure d'accueil.

Selon un autre aspect particulièrement avantageux de l'invention, l'une au moins des faces latérales supérieure, inférieure ou arrière de la structure est pourvue d'ouvertures de circulation d'air et/ou de passage de câbles électriques. Cet aspect de l'invention tire parti du fait qu'une protection électromagnétique efficace peut être obtenue grâce à des surfaces qui ne sont pas nécessairement pleines mais qui peuvent être pourvues d'ouvertures de tailles adaptées à la protection électromagnétique recherchée. Dans ce cas, on peut prévoir que, à proximité de sa face arrière, la structure d'accueil comprend des connecteurs aptes à coopérer avec des connecteurs solidaires des cartes et prévus sur le tiroir, alors que la face arrière de cette structure est une grille pourvue d'ouvertures de passage de câbles de raccordement des connecteurs de la structure. Il est ainsi possible d'alimenter les connecteurs, qui sont situés dans le volume intérieur de la structure d'accueil, à travers la face arrière sans pour autant perturber la fonction de protection électromagnétique obtenue.

Par ailleurs, les faces supérieure et inférieure de la structure d'accueil peuvent être formées de plaques percées d'ouvertures de circulation d'air, ce qui facilite le refroidissement des composants électroniques portés par les cartes. Dans ce cas, la somme des aires des ouvertures de chacune des faces supérieure et inférieure est approximativement égale à la surface de passage d'air, en vertical, dans le tiroir.

On peut en outre prévoir que la dimension maximale des ouvertures est largement inférieure à la longueur d'onde minimale des ondes électromagnétiques contre laquelle le tiroir devrait être isolé. Ainsi, les ondes électromagnétiques ne risquent pas de se propager à travers de ces ouvertures.

L'invention est également applicable au cas où la structure d'accueil est apte à recevoir plusieurs tiroirs. Dans ce cas, les logements d'accueil de deux tiroirs voisins sont séparés par une plaque intermédiaire électriquement conductrice apte à créer une isolation électromagnétique entre ces logements. On peut prévoir que cette plaque intermédiaire est pourvue d'ouvertures de circulation d'air et/ou de passage de câbles électriques et porte des moyens élastiques de liaison électrique avec les faces avant des tiroirs reçus dans ces deux logements.

L'invention sera mieux comprise et d'autres avantages de celle-ci apparaîtront plus clairement à la lumière de la description qui va suivre de deux modes de réalisation d'un dispositif de protection électromagnétique conforme à son principe, donnée uniquement à titre d'exemple et faite en référence aux dessins annexés dans lesquels :

-    la figure 1 est une vue en perspective éclatée par l'arrière d'un dispositif conforme à un premier mode de réalisation de l'invention ;
-    la figure 2 est une coupe verticale du dispositif de la figure 1 en cours d'introduction du tiroir dans sa structure d'accueil, un détail II étant représenté à plus grande échelle ;
-    la figure 3 est une coupe transversale partielle du tiroir selon la ligne III-III à la figure 2 ;
-    la figure 4 est une coupe analogue à la figure 2 alors que le tiroir est en position connectée dans la structure d'accueil, un détail IV étant représenté à plus grande échelle et
-    la figure 5 est une coupe verticale d'une structure d'accueil conforme à un second mode de réalisation de l'invention.

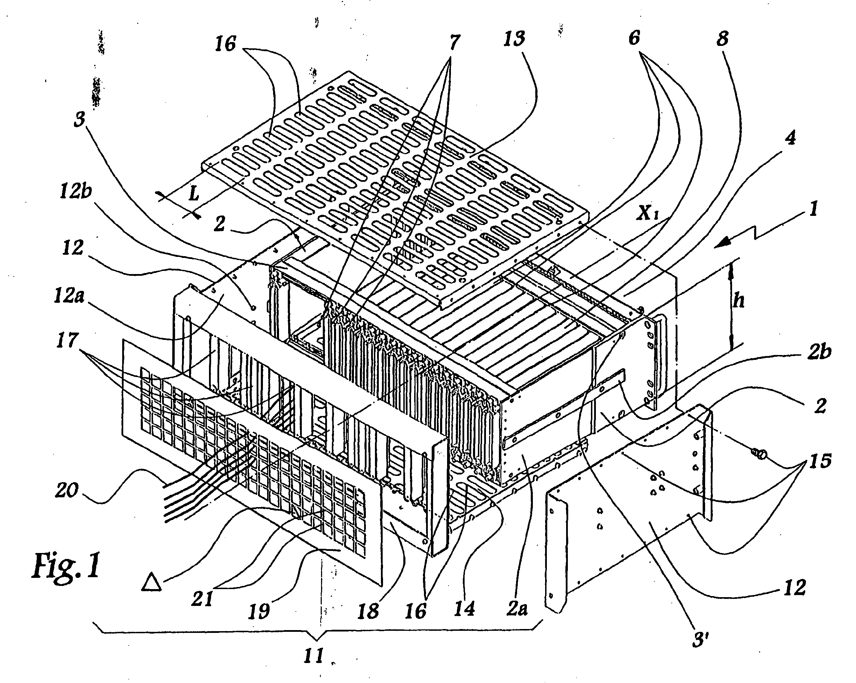

Le tiroir 1 représenté aux figures 1 à 4 est normalisé et dit "débrochable". Il est conforme à l'enseignement de FR-A-2 743 977 et constitué de deux flasques 2 reliés entre eux par quatre poutres 3 disposées pour deux d'entre-elles en partie supérieure du tiroir 1 et pour les deux autres en partie inférieure du tiroir. Les éléments 2 et 3, assemblés par des vis 3', constituent la structure du tiroir 1.

Les éléments 2 et 3 constituent la structure du tiroir 1. Les faces extérieures 2a des flasques 2 portent des glissières 2b s'étendant selon une direction $X_1$ globalement horizontale. Une face avant 4 est prévue sur le tiroir 1 du côté destiné à faire face à un opérateur. Cette face avant est fixée par des vis 5 sur les flasques 2 et/ou les poutres 3.

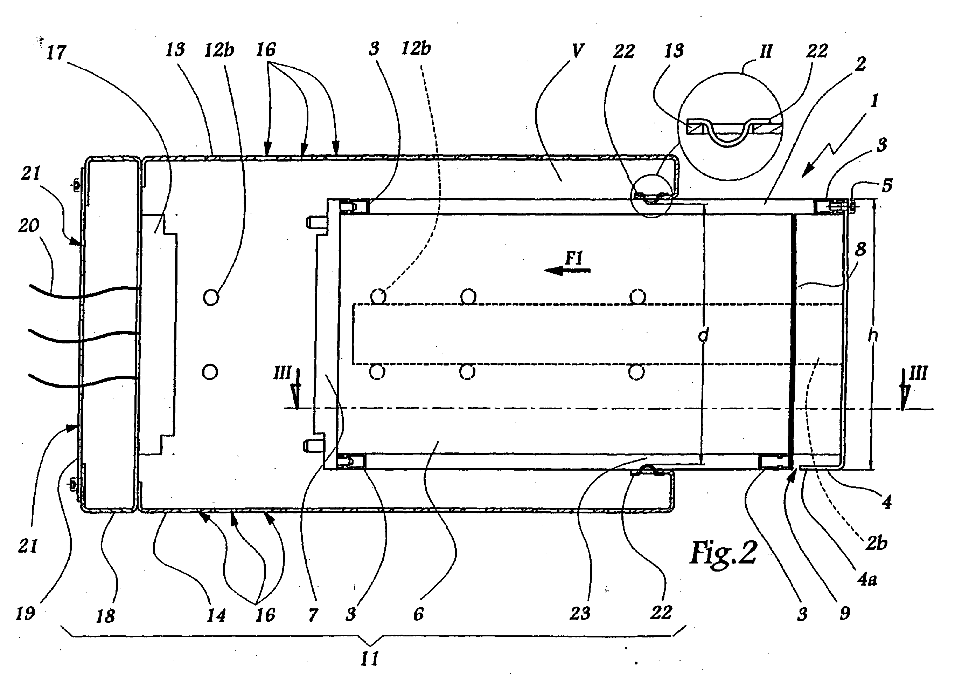

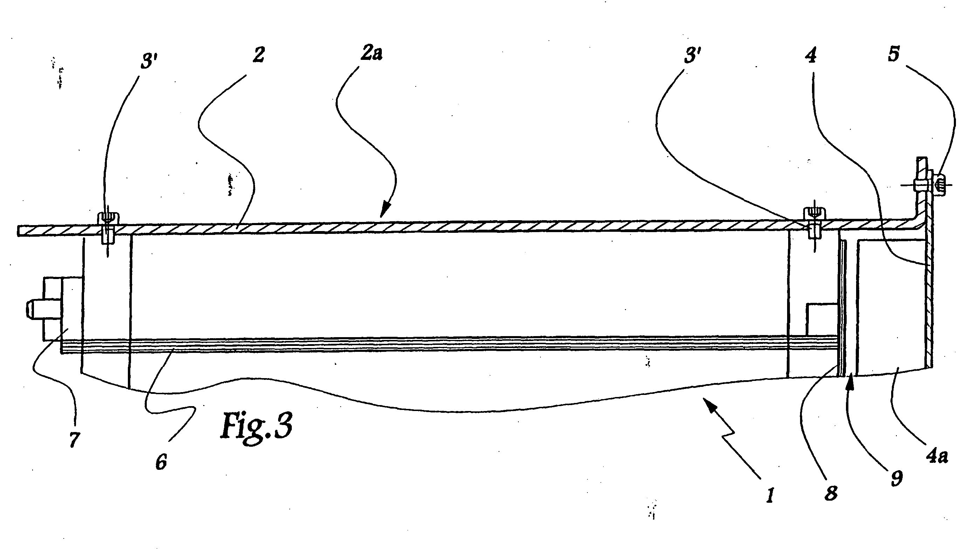

En partie basse, la face avant 4 est pourvue d'un retour 4a s'étendant en direction de la poutre 3 la plus proche. La fixation de la face avant 4 sur la structure du tiroir 1 peut ainsi être réalisée uniquement grâce aux vis 5 visibles à la figure 3 et coopérant avec les flasques 2, les vis 5 visibles à la figure 2 et coopérant avec les poutres 3 pouvant être supprimées. Ceci améliore les temps de montage et de démontage de la face avant 4 sur le tiroir 1. D'autres modes de montage de la face avant 4 sur le tiroir 1 peuvent être envisagés.

Des cartes électroniques 6 sont disposées dans le tiroir 1 parallèlement aux flasques 2 et entre ceux-ci. Du côté opposé à la face avant 4, les cartes 6 sont chacune munies d'un connecteur 7.

A l'opposé des connecteurs 7, les cartes 6 sont chacune reliées à une carte-mère 8 disposée parallèlement à la face avant 4, à proximité de celle-ci.

Comme il ressort à la fois des figures 2 et 3, le mode de fixation de la face avant 4 sur les poutres 3 du tiroir 1 et sur les flasques 2 permet de créer une continuité électrique entre, d'une part, cette face avant qui est pleine ou ajourée selon les besoins de la compatibilité électromagnétique et, d'autre part, les poutres 3 et les flasques 2. En revanche, il demeure une fente 9 qui peut être le lieu d'une "fuite électromagnétique" en partie basse du tiroir entre le retour 4a et la poutre 3 la plus proche.

La structure d'accueil 11 comprend deux flasques latéraux 12 pleins et dont les faces intérieures 12a sont pourvues de pions 12b prévus pour coopérer avec les glissières 2b du tiroir 1 pour un guidage en translation du tiroir 1 dans la structure 11 selon une direction $X_1$. Une plaque supérieure 13 et une plaque inférieure 14 sont tendues entre les flasques 12 en étant respectivement rendues solidaires des bords supérieurs et inférieurs de ces flasques grâce à des vis 15. Les plaques 13 et 14 sont percées de lumières oblongues 16 réparties sur leur surface.

La dimension maximale, c'est-à-dire la longueur L, des lumières 16 est choisie de telle sorte qu'elle respecte la relation suivante :

$$L \ll \lambda = c/f$$

où

? est la longueur d'onde minimale des ondes électromagnétiques dont on souhaite empêcher la propagation en direction du tiroir 1 ou à partir de celui-ci ;
c est la vitesse de la lumière et
f est la fréquence de ces ondes.

La surface totale des lumières 16 de la plaque 13 et des lumières 16 de la plaque 14 est approximativement égale à la surface de passage d'air, en vertical, à l'intérieur du tiroir 1, c'est-à-dire, en vue de dessus du tiroir 1, à l'espace entre les poutres verticales 3 et les flasques 2 qui n'est pas occupé par les cartes électroniques 6 et 8.

En partie arrière, la structure d'accueil 11 comprend des connecteurs 17 montée sur un support 18, ces connecteurs 17 étant prévus pour coopérer avec les connecteurs 7 du tiroir 1 en étant débrochables avec ceux-ci. Une grille 19 est disposée parallèlement au support 18 et permet de fermer vers l'arrière le volume défini entre les flasques 12 et les plaques 13 et 14. Dans ce sens, la grille 19 constitue la face arrière de la structure d'accueil 11.

Les éléments 12, 13, 14, 18 et 19 sont électriquement conducteurs et, du fait de leur assemblage, électriquement connectés entre eux.

Les connecteurs 17 sont reliés à l'environnement de la structure 11 par des câbles conducteurs 20 qui traversent la grille 19 en passant à travers des ouvertures 21 de cette grille. Dans l'exemple représenté, ces ouvertures sont sensiblement carrées et l'on note ? leur diagonale. Comme précédemment, la diagonale ? est liée à la longueur d'onde ? des ondes électromagnétiques environnantes par la relation :

$$\Delta \ll \lambda = c/f.$$

Du côté avant, c'est-à-dire à l'opposé des éléments 17 à 21, la structure 11 est pourvue de ressorts élastiques 22 disposés en partie supérieure et inférieure d'une ouverture 23 à travers laquelle le tiroir 1 peut être introduit dans la structure 11 en faisant coopérer les rails 2b avec les pions 12b le sens d'introduction étant représenté par la flèche $F_1$ à la figure 2.

Selon une première variante non représentée de l'invention, les ressorts 22 peuvent être montés sur le tiroir 1. Selon une seconde variante, également non représentée, les ressorts peuvent être disposés en alternance sur la structure 11, par exemple en partie inférieure, et sur le tiroir, par exemple en partie supérieure, ou inversement.

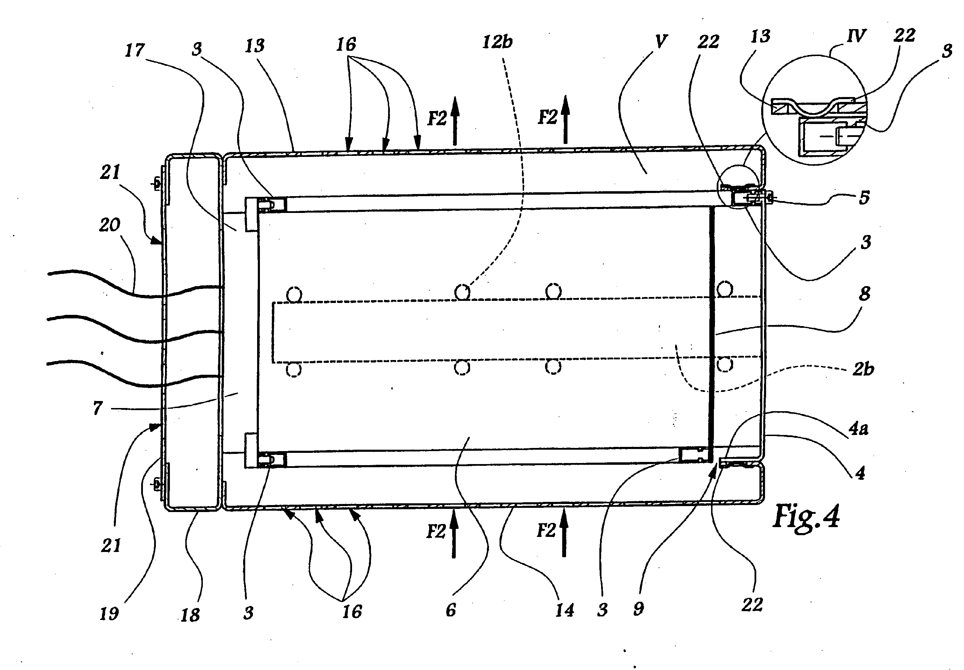

Comme représenté à la figure 4, et notamment au détail IV, lorsque le tiroir 1 est en place dans la structure 11, sa face avant 4 est en appui contre les ressorts 22 en partie basse et la poutre 3 la plus proche est en appui contre des ressorts 22 en partie haute. Il est ainsi formé une continuité électrique entre cette face avant 4 et l'ensemble de la structure 11, notamment le flasque 12 et les plaques 13 et 14.

Dans cette position, les connecteurs 7 et 17 sont embrochés et les cartes 6 sont reliées à leur environnement par les câbles 20. Les cartes 6 sont alors incluses à l'intérieur d'un volume fermé V défini par la face avant 4, les flasques 12, les plaques 13 et 14 et la grille 19, une continuité électrique étant réalisée entre ces différentes surfaces de telle sorte qu'une isolation électromagnétique du volume V est obtenue, les ouvertures 16 et 21 ménagées dans certaines de ces surfaces permettant, pour certaines d'entre elles, une circulation d'air de refroidissement telle que représenté par les flèches $F_2$ à la figure 4 et, pour les autres, un raccordement électrique des cartes 6 grâce aux câbles 20.

En particulier, la fente 9 précédemment identifiée est incluse dans le volume V de sorte qu'une éventuelle fuite électromagnétique à ce niveau reste confinée dans ce volume.

Pour assurer un contact électrique efficace entre le tiroir 1 et les ressorts 22, on prévoit que la hauteur $\underline{h}$ du tiroir 1 est supérieure à la distance $\underline{d}$ séparant les ressorts 22 lorsqu'ils n'interfèrent pas avec le tiroir 1. Ceci permet une compression des ressorts 22 et assure un contact électrique efficace entre ces ressorts et le tiroir 1, au niveau d'une poutre 3 ou de la face avant 4.

Selon des variantes non représentées de l'invention, les câbles 20 peuvent pénétrer à l'intérieur du volume V par n'importe qu'elle surface de la structure d'accueil 11, en particulier par l'une des plaques 13 ou 14. Selon une autre variante de l'invention, les flasques latéraux 12 peuvent être pourvus d'ouvertures de passage de câbles conducteurs ou de circulation d'air. De même, la face avant 4 peut être pourvue d'ouvertures pour la circulation d'air.

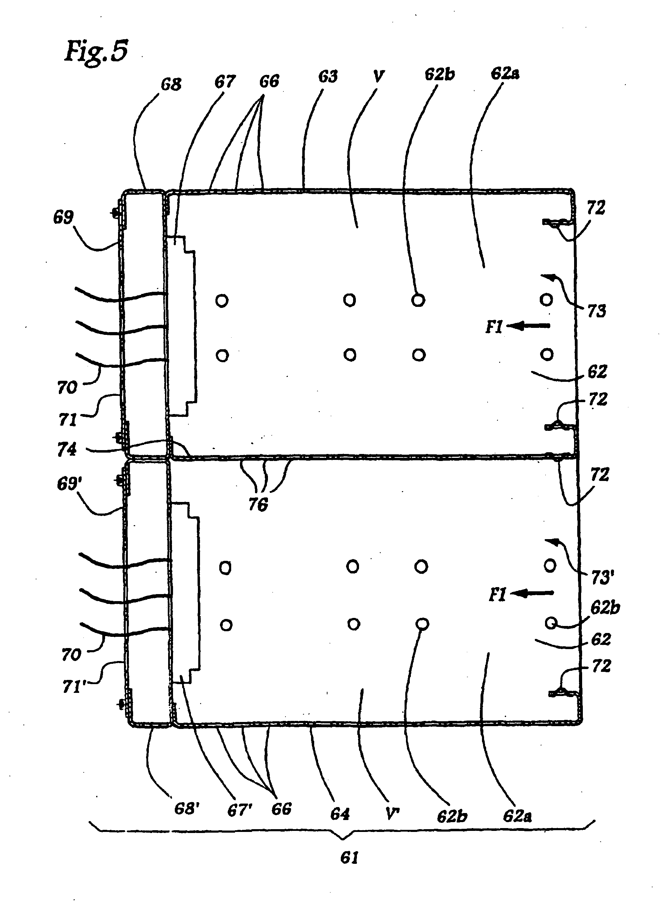

Dans le second mode de réalisation de l'invention représenté à la figure 5, les éléments analogues à ceux du premier mode de réalisation portent des références identiques augmentés de 50. La structure d'accueil 61 de ce mode de réalisation définit deux volumes V et V' de réception de tiroirs non représenté et comprend des flasques latéraux 62 dont les faces internes 62a sont pourvues de pions 62b alors qu'une plaque supérieure 63 et une plaque inférieure 64 sont reliées aux flasques 62 par tous moyens appropriés et, par exemple, par des vis. Chacune des plaques 63 et 64 est pourvue de lumière 66 de passage d'air de refroidissement.

Des connecteurs 67 et 67' sont montés sur des supports 68 et 68' alors que deux grilles 69 et 69' sont prévues à l'arrière de la structure 61 entre les plaques 63 et 64. Des câbles conducteurs 70 sont prévus pour alimenter les connecteurs 67 à travers des ouvertures, 71 et 71', des grilles 69 et 69'.

Des ressorts 72 sont prévus en parties inférieure et supérieure de chaque ouverture 73 et 73' par lesquelles peuvent être introduits les tiroirs analogues au tiroir 1 du premier mode de réalisation comme représenté par les flèches F1.

Une plaque intermédiaire 74 est disposée entre les volumes V et V' et est pourvue de lumières 76 selon une répartition analogue à celle des lumières 66 des plaques 63 et 64. Comme précédemment, l'aire total des lumières 66 de chacune des plaques 63 et 64 et des lumières 76 de la plaque 74 est sensiblement égale à la surface de passage d'air en vertical dans un tiroir prévu pour être monté à l'intérieur des volumes V et V'.

La plaque 74 porte deux rangées de ressorts 72 prévus pour la relier électriquement respectivement avec la partie inférieure de la face avant d'un tiroir reçu dans le volume V et avec la poutre supérieure avant d'un tiroir reçu dans le volume V.

La structure d'accueil 61 ainsi constituée permet de recevoir deux tiroirs électroniques, chaque tiroir étant protégé sur le plan de la compatibilité électromagnétique de l'extérieur mais également du tiroir voisin, alors que la structure 61 est simple sur le plan de la fabrication. On peut encore simplifier la structure 61 en réalisant en une seule pièce les flasques 62, de chaque côté des deux tiroirs, et/ou les grilles 69 et 69'.

Bien entendu, une stucture apte à recevoir trois ou plus de trois tiroirs peut être prévue sur la base du mode de réalisation de la figure 5.

## Revendications

1. Dispositif de protection électromagnétique pour un tiroir (1) équipé de cartes électroniques (6) et apte à être introduit dans une structure d'accueil (11) à travers une ouverture (23) prévue en face avant de ladite structure, ledit dispositif comprenant six faces (4, 12, 13, 14, 19) réparties autour desdites cartes (6), l'une desdites faces dudit dispositif étant formée par la face avant (4) dudit tiroir (1) **caractérisé en ce que** les cinq autres faces dudit dispositif sont formées par les faces latérales (12), supérieure (13), inférieure (14) et arrière (19) de ladite structure d'accueil (11) qui sont électriquement conductrices.

2. Dispositif selon la revendication 1, **caractérisé en ce qu'**il comprend des moyens élastiques (22) de liaison électrique entre ladite face avant (4) dudit tiroir (1) et ladite structure d'accueil (11).

3. Dispositif selon la revendication 2, **caractérisé en ce que** lesdits moyens élastiques sont formés par des ressorts (22) électriquement conducteurs disposés sur des bords de ladite ouverture (23) prévue en face avant de la structure (11) et/ou sur ledit tiroir (1).

4. Dispositif selon l'une des revendications précédentes, **caractérisé en ce que** l'une au moins desdites faces latérales (12), supérieure (13), inférieure (14) ou arrière (19) est pourvue d'ouvertures (16, 21) de circulation d'air et/ou de passage de câbles électriques (20).

5. Dispositif selon la revendication 4, **caractérisé en ce que** ladite structure d'accueil (11) comprend, à proximité de sa face arrière (19), des connecteurs (17) aptes à coopérer avec des connecteurs (7) solidaires desdites cartes (6), et **en ce que** ladite face arrière est une grille (19) pourvue d'ouvertures (21) de passage de câbles (20) de raccordement desdits connecteurs (17) de ladite structure.

6. Dispositif selon l'une des revendications 4 ou 5, **caractérisé en ce que** lesdites faces supérieure et inférieure sont formées de plaques (13, 14) percées d'ouvertures (16) de circulation d'air.

7. Dispositif selon la revendication 6, **caractérisé en ce que** la somme des aires des ouvertures (16) de chacune desdites faces supérieure (13) et inférieure (14) est approximativement égale à la surface de passage d'air en vertical dans ledit tiroir (1).

8. Dispositif selon l'une des revendications 4 à 7, **caractérisé en ce que** la dimension maximale (L, $\Delta$) desdites ouvertures (16, 21) est largement inférieure à la longueur d'onde minimale ($\lambda$) des ondes électromagnétiques contre lesquelles ledit tiroir (1) doit être isolé.

9. Dispositif selon l'une des revendications précédentes, **caractérisé en ce que** ladite structure (11) est apte à recevoir plusieurs tiroirs, les logements d'accueil (V, V') de deux tiroirs voisins étant séparés par une plaque (74) électriquement conductrice intermédiaire apte à créer une isolation électromagnétique entre lesdits logements.

10. Dispositif selon la revendication 9, **caractérisé en ce que** ladite plaque intermédiaire (74) est pourvue d'ouvertures (76) de circulation d'air et/ou de passage de câbles électrique et porte des moyens élastiques (72) de liaison électrique avec les faces avant des tiroirs reçus dans lesdits deux logements (V, V').

## Claims

1. Electromagnetic protection device for a drawer (1) which is fitted with electronic boards (6) and which is capable of being introduced into a receiving structure (11) through an opening (23) provided on the front face of the said structure, where the said device includes six faces (4, 12, 13, 14, 19) distributed around the said boards (6), with one of the said faces of the said device being formed by the front face (4) of the said draw (1), **characterised by** the fact that the other five faces of the said device are formed by the side (12), upper (13), lower (14) and rear (19) faces of the said receiving structure (11), which are electrically conductive.

2. Device according to claim 1, **characterised by** the fact that it includes elastic means (22) of electrical connection between the said front face (4) of the said drawer (1) and the said receiving structure (11).

3. Device according to claim 2, **characterised by** the fact that the said elastic means are formed by electrically conductive springs (22) arranged on the edges of the said opening (23) provided on the front face of the structure (11) and/or on the said drawer (1).

4. Device according to one of the preceding claims, **characterised by** the fact that at least one of the said side (12), upper (13), lower (14) or rear (19) faces is provided with openings (16, 21) for the circulation of air and/or the passage of electrical cables (20).

5. Device according to claim 4, **characterised by** the fact that the said receiving structure (11) includes, in proximity to its rear face (19), connectors (17) designed to fit to connectors (7) which are solidly attached to the said boards (6), and by the fact that the said rear face is a grille (19) provided with openings (21) for the passage of cables (20) for connection of the said connectors (17) of the said structure.

6. Device according to one of claims 4 or 5, **characterised by** the fact that the said upper and lower faces are formed of plates (13, 14) pierced by openings (16) for the circulation of air.

7. Device according to claim 6, **characterised by** the fact that the sum of the areas of the openings (16) of each of the said upper (13) and lower (14) faces is approximately equal to the vertical air passage surface area in the said drawer (1).

8. Device according to one of claims 4 to 7, **characterised by** the fact that the maximum dimension (L, $\Delta$) of the said openings (16, 21) is significantly less than the minimum ($\Delta$) wavelength of the electromagnetic waves from which the said drawer (1) must be isolated.

9. Device according to one of the preceding claims, **characterised by** the fact that the said structure (11) is designed to receive several drawers, where the receiving housings (V, V') of two adjacent drawers are separated by an intermediate electrically conductive plate (74) designed to create electromagnetic isolation between the said housings.

10. Device according to claim 9, **characterised by** the fact that the said intermediate plate (74) is provided with openings (76) for the circulation of air and/or the passage of electrical cables and holds elastic means (72) of electrical connection with the front faces of the drawers held in the said two housings (V, V').

**Patentansprüche**

1. Vorrichtung zum elektromagnetischen Schutz für einen Einschub (1), welcher mit elektronischen Karten (6) versehen und für ein Einführen in einen Aufnahmeaufbau (11) durch eine Öffnung (23) eingerichtet ist, die an der Vorderseite des Aufbaus vorgesehen ist, wobei die Vorrichtung sechs Flächen (4, 12, 13, 14, 19) aufweist, die um diese Karten (6) herum verteilt sind, wobei die eine der Flächen der Vorrichtung durch die Vorderwand (4) des Einschubs (1) gebildet ist, **dadurch gekennzeichnet, dass** die fünf weiteren Flächen der Vorrichtung, durch die Seitenflächen (12), die obere Fläche (13), die untere Fläche (14) und die hintere Fläche (19) des Aufnahmeaufbaus (11), die elektrisch leitfähig sind, gebildet sind.

2. Vorrichtung nach Anspruch 1, **dadurch gekennzeichnet, dass** sie elastische Mittel (22) zur elektrischen Verbindung zwischen der Vorderfläche (4) des Einschubs (1) und dem Aufnahmeaufbau (11) aufweist.

3. Vorrichtung nach Anspruch 2, **dadurch gekennzeichnet, dass** die elastischen Mittel durch elektrisch leitende Federn (22) gebildet sind, die an den Rändern der Öffnung (23), die an der Vorderseite des Aufbaus (11) vorgesehen sind, und/oder an dem Einschub (1) angeordnet sind.

4. Vorrichtung nach einem der vorstehenden Ansprüche, **dadurch gekennzeichnet, dass** wenigstens eine der seitlichen Flächen (12), der oberen Fläche (13), der unteren Fläche (14) oder der hinteren Fläche (19) mit Luftzirkulationsöffnungen (16, 21) und/oder Durchtrittsöffnungen (20) für elektrische Kabel versehen ist.

5. Vorrichtung nach Anspruch 4, **dadurch gekennzeichnet, dass** der Aufnahmeaufbau (11) in der Nähe seiner hinteren Fläche (19) Verbinder (17) aufweist, die für ein Zusammenwirken mit mit den Karten (6) fest verbundenen Verbindern (7) eingerichtet sind, und dass die hintere Fläche ein Gitter (19) ist, das mit Öffnungen (21) für den Durchtritt von Anschlusskabeln (20) der Verbinder (17) des Aufbaus versehen ist.

6. Vorrichtung nach einem der Ansprüche 4 oder 5, **dadurch gekennzeichnet, dass** die obere und die untere Fläche aus Platten (13, 14) gebildet sind, die von Luftzirkulationsöffnungen (16) durchsetzt sind.

7. Vorrichtung nach Anspruch 6, **dadurch gekennzeichnet, dass** die Summe der Querschnittsflächen der Öffnungen (16) jeder der oberen Fläche (13) und unteren Fläche (14) ungefähr gleich der Luftdurchtrittsoberfläche in senkrechter Richtung in dem Einschub (1) ist.

8. Vorrichtung nach irgendeinem der Ansprüche 4 bis 7, **dadurch gekennzeichnet, dass** die Maximalabmessung (L, $\Delta$) der Öffnungen (16, 21) deutlich kleiner als die minimale Wellenlänge ($\Delta$) der elektromagnetischen Wellen ist, gegenüber welchen der Einschub (1) isoliert werden muss.

9. Vorrichtung nach einem der vorstehenden Ansprüche, **dadurch gekennzeichnet, dass** der Aufbau (11) zur Aufnahme mehrerer Einschübe eingerichtet ist, wobei die Aufnahmen (V, V') von zwei benachbarten Einschüben durch eine elektrisch leitende Zwischenplatte (74) getrennt sind, die für die Erzeugung einer elektromagnetischen Isolation zwischen den Aufnahmen eingerichtet ist.

10. Vorrichtung nach Anspruch 9, **dadurch gekennzeichnet, dass** die Zwischenplatte (74) mit Luftzirkulationsöffnungen (76) und/oder Durchtrittsöffnungen für elektrische Kabel versehen ist und elastische Mittel (72) zur elektrischen Verbindung zu den Vorderflächen der in den zwei Aufnahmen (V, V') aufgenommen Einschübe trägt.

Fig.1

Fig.2

Fig.3

EP 1 073 324 B1

Fig.4

Fig.5

EP 1 073 324 B1

## RÉFÉRENCES CITÉES DANS LA DESCRIPTION

**Documents brevets cités dans la description**

- DE 4309084

- FR 2743977 A